# EUROPEAN PATENT SPECIFICATION

(11) **EP 4 044 366 B1**
(45) Date of publication and mention of the grant of the patent: **25.10.2023**
(21) Application number: 21156928.0
(22) Date of filing: 12.02.2021
(51) Int. Cl.: H01Q 1/22, H01Q 9/28, H01Q 21/08, H01Q 21/26

(54) **AN INTEGRATED CIRCUIT PACKAGE COMPRISING A CROSSED DIPOLE ANTENNA**
INTEGRIERTE SCHALTUNGSPACKUNG MIT GEKREUZTER DIPOLANTENNE
BOÎTIER DE CIRCUIT INTÉGRÉ COMPRENANT UNE ANTENNE DIPÔLE CROISÉE

(43) Date of publication of application: 17.08.2022
(73) Proprietor: Sivers Wireless AB, 164 29 Kista (SE)
(72) Inventor: Öjefors, Erik, 753 31 Uppsala (SE); Dancila, Dragos, 756 59 Uppsala (SE); Aziz, Imran, Tehsil Kharian, District Gujrat 50991 (PK); Hanning, Johanna, 422 56 Hisings Backa (SE)
(74) Representative: AWA Sweden AB

(56) References cited:
- EP-A1- 3 346 544
- US-A1- 2010 193 935
- US-A1- 2017 236 776
- WOJNOWSKI M ET AL: "A 77-GHz SiGe single-chip four-channel transceiver module with integrated antennas in embedded wafer-level BGA package", ELECTRONIC COMPONENTS AND TECHNOLOGY CONFERENCE (ECTC), 2012 IEEE 62ND, IEEE, 29 May 2012 (2012-05-29), pages 1027-1032, XP032210715, DOI: 10.1109/ECTC.2012.6248962 ISBN: 978-1-4673-1966-9

## Description

### FIELD OF THE INVENTION

The present invention is generally related to integrated circuit packages comprising at least one crossed dipole antenna.

### BACKGROUND OF THE INVENTION

The use of smart devices is increasing exponentially, and smart devices often need to be able to transmit and to receive signals via a wireless communication link. Further, the advent of 5G has increased, and continues to increase, the use of antennas operating within the 1 to 30 GHz spectrum. Therefore, the use of millimeter wave antennas is rapidly increasing. Some solutions use antennas integrated with an integrated circuit chip. The integrated circuit chip may, for example, be a radio frequency chip using integrated fan-out wafer level packaging (InFO-WLP) technology, or similar packing technologies. The transmission lines of such solutions typically use a rectangular waveguide to transmit and/or receive signal to/from antennas of an integrated circuit package. A main driver for the combination of InFO-WLP and integrated antennas has been the reduced signal loss in the feedline between the chip and the antenna. A problem of the current technology is its inability to provide match polarization for a circular polarized antenna. Additionally, a problem of the current technology is its mutual coupling and/or disturbances from other parts of a device which disturbs and/or blocks the antennas of the device.

US 9,583,811 B2 discloses a microwave device including a semiconductor package comprising a microwave semiconductor chip and a wave-guide part associated with the semiconductor package. Further examples of integrated circuit packages with antennas can be found in EP 3346544, Wojnowski M et al "A 77-GHz SiGe single-chip four-channel transceiver module with integrated antennas in embedded wafer-level BGA package", Electronic components and technology conference, 2012 IEEE 62nd, 29 May 2012, US 2010/193935, and US 2017/236776.

### SUMMARY OF THE INVENTION

It is of interest to provide an integrated circuit package comprising at least one crossed dipole antenna formed in a redistribution metal layer of integrated circuit package, which has a small form factor, a reduced disturbance, and an increased antenna gain. Additionally, it is of interest to provide a circular polarized antenna, thereby making the orientation independent of an antenna element of a device with which the circular polarized antenna is communicating with. Further, by providing the antenna in package, the need for special high frequency materials is replaced with the use of standard cost-effective PCB material.

These interests are met by providing an arrangement having the features in the independent claims. Preferred embodiments are defined in the dependent claims.

Hence, according to an aspect of the present invention, there is provided an integrated circuit package. The integrated circuit package may be an embedded wafer level ball grid array, eWLB. The integrated circuit package comprises a transceiver radio-frequency integrated circuit, RFIC. The RFIC may be understood as, for example, a chip, a chipset and/or a die. The RFIC is a transceiver RFIC. The RFIC may be a transceiver RFIC configured for any frequency between 1 to 45 GHz. Preferably, the RFIC may be a 24.25 GHz - 29.5 GHz transceiver RFIC or a 37 GHz - 43.5 GHz transceiver RFIC. More preferably, the RFIC may be a 28 GHz transceiver RFIC. The integrated circuit package comprises at least one antenna array. The antenna array may be configured for beam steering. The antenna array may be capable of beam steering of ±50°. The at least one antenna array is formed in a redistribution metal layer, RDL, of the integrated circuit package. By the term "the at least one antenna array is formed in a redistribution metal layer, RDL, of the integrated circuit package" it may be understood that, for example, the at least one antenna array is comprised by the RDL, the at least one antenna array is realized in the RDL, and/or that the at least one antenna array is arranged within the RDL. The at least one antenna array may be a planar antenna array. The at least one antenna array is arranged in a fan-out area of the integrated circuit package. The at least one fan-out area may comprise mold compound. The at least one antenna array may be configured to transmit and/or receive signals through the mold compound of the fan-out area. The at least one antenna array comprises at least one crossed dipole antenna. Each crossed dipole antenna comprises a first dipole comprising two first legs, a second dipole comprising two second legs, and two leg pairs. The first legs and the seconds leg are dipole legs of the first dipole and the second dipole, respectively. Each leg pair comprises one first leg of the first dipole and one second leg of the second dipole of its corresponding crossed dipole antenna. The integrated circuit package comprises at least one pair of feed lines formed in the RDL. Each feed line of each pair of feed lines is coupled between a respective leg pair of a respective crossed dipole antenna and the RFIC. Each pair of feed lines extends from a center of the respective crossed dipole antenna towards the RFIC between a neighboring first leg and a neighboring second leg of the two leg pairs of the respective crossed dipole antenna. The neighboring first leg and the neighboring second leg belong to different leg pairs of the two leg pairs. The feed lines may be understood as, for example, transmission lines. Hence, the crossed dipole antennas and their respective feed lines may be realized in planar transmission line technology. In other words, the crossed dipole antennas and their respective feed lines may be realized in a single metal layer.

According to an aspect of the present invention, there is provided an arrangement. The arrangement may comprise an integrated circuit package according to another aspect of the invention. The arrangement may further comprise a heatsink element. The heatsink element may be arranged on the RFIC of the integrated circuit package.

According to an aspect of the present invention, there is provided a system. The system may comprise an arrangement according to another aspect of the invention. The system may further comprise a printed circuit board, PCB. The arrangement may be mounted to the PCB. By the term "mounted" is further meant, for example, attached, arranged and/or soldered.

The at least one antenna array and the at least one pair of feed lines may be arranged in a plane of the RDL. In other words, the at least one antenna array and the at least one pair of feed lines may be arranged in and/or along a plane, wherein in the plane is arranged within the RDL. Said plane may be further be understood as a surface. Hence, the form factor of the integrated circuit package may thereby be reduced. The at least one antenna array and the at least one pair of feed lines may be realized in planar technology. Further, the at least one antenna array and the at least one pair of feed lines may be realized in planar technology within the RDL.

Each pair of feed lines may be extending from the center of the respective crossed dipole antenna in a first direction. The first direction may be arranged at an angle of substantially 45° with regards to longitudinal axes of the neighboring first leg and the neighboring second leg of the two leg pairs. The neighboring first leg and the neighboring second leg may be comprised by different leg pairs of the two leg pairs. Hence, interference reduced antenna performance caused by feedlines on the crossed dipole antenna may be mitigated and/or reduced. In other words, the first direction may be arranged at an angle of substantially 45° with regards to longitudinal axes of a first leg of a first leg pair of the two leg pairs and a second leg of a second leg pair of the two leg pairs. Correspondingly, the first direction may be arranged at an angle of substantially 45° with regards to longitudinal axes of a second leg of a first leg pair of the two leg pairs and a first leg of a second leg pair of the two leg pairs. The interference may be at a minimum when the feed lines are arranged at an angle of substantially 45° with regards to longitudinal axes of a neighboring first leg and a neighboring second leg of the two leg pairs. However, it is to be understood that said angle may be between 35 to 45° with regards to a longitudinal axis of one of the neighboring first leg and the neighboring second leg. Each pair of feed lines may extend along the first direction from the center of the respective crossed dipole antenna to a turning point. A distance between the center and the turning point may be less than a length of the second leg. The feed lines may be arranged parallel to each other from the center of the crossed dipole antenna. A distance between the two feed lines may be substantially zero, or less than a width of the feed lines.

Each crossed dipole may be a circular polarized antenna. In order for a crossed dipole antenna to be a circular polarized antenna there has to be a relation between the lengths of the first legs and second legs of the crossed dipole antenna. For a crossed dipole antenna arranged in a redistribution metal layer, without feed lines coupled to said crossed dipole antenna, or feed lines extending orthogonally of the crossed dipole antenna, the relation is 1.55. In order to maintain circular polarization of the crossed dipole antenna when feed lines are introduced in the redistribution metal layer and coupled to the crossed dipole antenna, the relation has to be adjusted. A first length of each first leg of the at least one crossed dipole antenna may be longer than a second length of each second leg of the at least one crossed dipole antenna. The first length may have to be increased by 11% and the second length may have to be increased by 6% in order to adjust the specific relation such that the crossed dipole antenna to which feed lines are coupled maintains circular polarization. The relation between a first length of each first leg of the at least one crossed dipole antenna and a second length of each second leg of the at least one crossed dipole antenna is between 1.52 and 1.68. Preferably, the relation between a first length of each first leg of the at least one crossed dipole antenna and a second length of each second leg of the at least one crossed dipole antenna is 1.62. Thereby, the crossed dipole antenna may be a circular polarized antenna formed in a redistribution metal layer, which is coupled to feed lines formed in the same redistribution metal layer.

Lengths and widths of the legs of a crossed dipole antenna determine the impedance of the crossed dipole antenna. It is of interest to have relatively wide legs, since that makes production of said crossed dipole antenna easier. Further, wider legs reduce ohmic losses. A relation between length and width of first legs of a crossed dipole antenna may be between 6.8 and 7.6. Preferably, the relation between length and width of first legs of a crossed dipole antenna may be 7.2. It is to be understood that the length of the first legs is greater than the width of the first legs. A relation between length and width of second legs of a crossed dipole antenna may be between 4.2 and 4.8. Preferably, the relation between length and width of second legs of a crossed dipole antenna may be 4.5. It is to be understood that the length of the second legs is greater than the width of the second legs. The width of the first legs and the second legs is equal. The width of the first legs and the second legs may be between 0.018 and 0.022 of a wavelength which the crossed dipole antenna is configured for. Preferably, the width of the first legs and the second legs may be 0.02 of a wavelength which the crossed dipole antenna is configured for. The length of the first legs may be 0.14, or 1/7, of a wavelength which the crossed dipole antenna is configured for. The length of the second legs may be 0.09, or 1/11, of a wavelength which the crossed dipole antenna is configured for. The wavelength which the crossed dipole antenna is configured for may be understood as a free space wavelength.

Thereby, a phase difference between the first dipole and the second dipole of the crossed dipole antenna can be adjusted. In other words, the phase difference between the first dipole and the second dipole of the crossed dipole antenna can be adjusted by adjusting the first length and the second length.

The first dipole of each crossed dipole antenna may have a first angle of input admittance and the second dipole of each crossed dipole antenna may have a second angle of input admittance. The first angle of input admittance and the second angle of input admittance may differ by 90°. The first length and the second length may be determined such that the first angle of input admittance and the second angle of input admittance differs by 90°.

The two feed lines may be understood as, for example, transmission lines, groundless transmission lines, differential transmission lines and/or groundless differential transmission lines. The two feed lines of pair of feed lines may each be fed a signal by the RFIC. The two signals fed to said two feed lines of each pair of feed lines may have a phase difference of 180°. The RFIC may feed a first signal to one feed line of pair of feed lines and a second signal to another feed line of said pair of feed lines. By the term "feed" it is further meant, for example, output, provide and/or supply. The RFIC may comprise at least two phase shifter outputs configured to feed the first signal and/or the second signal. A separate phase shifter output may be for the first signal and the second signal respectively.

The integrated circuit package may comprise at least two antenna arrays. A first antenna array of the at least two antenna arrays may be arranged in a first fan-out area of the fan-out area. A second antenna array of the at least two antenna arrays may be arranged in a second fan-out area of the fan-out area. The first fan-out area and the second fan-out area may be arranged at opposites sides of the RFIC. The first antenna array and the second antenna array of the at least two antenna arrays may be arranged at opposites sides of the RFIC.

Each antenna array may comprise at least four crossed dipole antennas. However, it is to be understood that each antenna array may comprise any number of crossed dipole antennas. For example, an antenna array may comprise, for example, one, two, three, four, five, six, seven, eight, or more crossed dipole antennas. Further, the integrated circuit package may comprise at least two antenna arrays, wherein different antenna arrays may comprise a different number of crossed dipole antennas. The crossed dipole antennas of an antenna array may be arranged in a row, a plurality of rows, a column, a plurality of columns, a grid, and/or a matrix. For example, the crossed dipole antennas of an antenna array may be arranged in along a number of aligned rows, wherein each row may comprise the same number of crossed dipole antennas.

The heatsink element may be configured to cool the RFIC. The heatsink element of the arrangement may be arranged between the first fan-out area and the second fan-out area. The heatsink element may be arranged on top of the RFIC. The heatsink may be arranged such that it does not cover the at least one antenna array. The heatsink may be arranged such that the first fan-out area and the second fan-out area are not covered by the heatsink element. Hence, disturbance and/or blockage of the at least one antenna array may be reduced. Additionally, the heatsink element may be at least a part of a reflector wall which may be configured to increase the gain of the at least one antenna array.

The PCB may comprise a reflective metal layer. The PCB may further comprise a plurality of vias. The RFIC of the printed circuit board may be mounted at the plurality of vias. The plurality of vias may be understood as, for example, a fencing, and/or a via fencing. The plurality of vias may be arranged through the PCB, or from a top side of the PCB towards a bottom side of the PCB, and/or from a top side of the PCB to the reflective metal layer of the PCB. The plurality of vias may be arranged along a rectangular shape. The rectangular shape may be arranged in a plane which is parallel to reflective metal layer. The plurality of vias may be at least a part of a reflector wall which may be configured to increase the gain of the at least one antenna array.

The at least one antenna array of the arrangement may be configured for communication at a specific wavelength. For example, the wavelength at 28 GHz is 10.7 mm, and the at least one antenna array may be configured for communication at a wavelength of 10.7 mm. By the term "communication" is further meant, for example, transmitting and/or receiving signals. The at least one antenna array may be arranged at a first distance from the reflective metal layer. The at least one antenna array may be arranged at a second distance from the plurality of vias. The first distance may be a quarter of the specific wavelength. Thereby producing constructive interference of the waves which may increase the antenna gain. The second distance may be between one-half and three-quarters of the specific wavelength. Thereby, the circular polarization of the crossed dipole antennas may be maintained. In other words, the performance of the circular polarization may be increased. Thereby the gain of the at least one antenna array may be increased. The heatsink element may have a height which is equal to the substantially three-tenths of the specific wavelength. Thereby the disturbance of the heatsink element is diminished, which optimizes the antenna gain. However, the heatsink element may have height which is less than three-tenths of the specific wavelength.

The heatsink element, the RFIC and the plurality of vias may form a reflector wall. The reflector wall may be arranged between antenna arrays of an integrated circuit package comprising at least two antenna arrays. The reflective metal layer and the reflector wall may form a corner reflector antenna. The placement of the corner reflector antenna may be configured to maintain the circular polarization of the crossed dipole antennas and not adversely affect the gain. Hence, the corner reflector antenna may increase the performance of the circular polarization.

### BRIEF DESCRIPTION OF THE DRAWINGS

This and other aspects of the present invention will now be described in more detail, with reference to the appended drawings showing embodiment(s) of the invention.
Fig. 1 schematically shows a cross-sectional view of an integrated circuit package according to an exemplifying embodiment of the present invention.
Fig. 2 schematically shows a perspective view of a crossed dipole antenna according to an exemplifying embodiment of the present invention.
Fig. 3 schematically shows a perspective view of an integrated circuit package according to an exemplifying embodiment of the present invention.
Fig. 4 schematically shows a cross-sectional view of a system according to an exemplifying embodiment of the present invention.
Fig. 5 schematically shows a perspective view of a system according to an exemplifying embodiment of the present invention.

### DETAILED DESCRIPTION

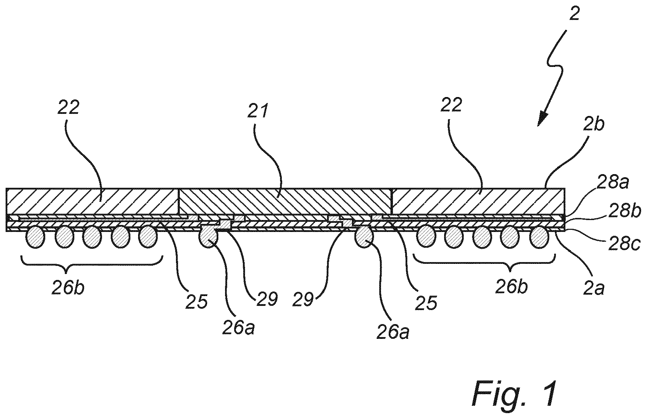

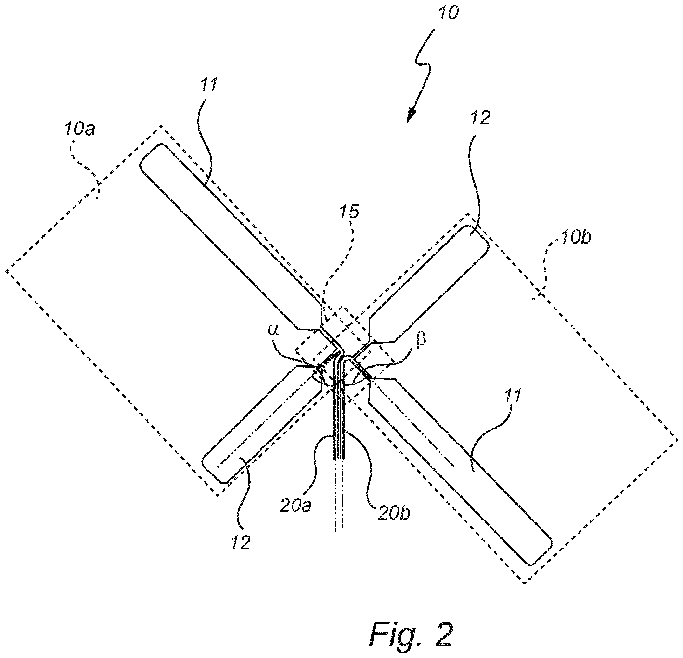

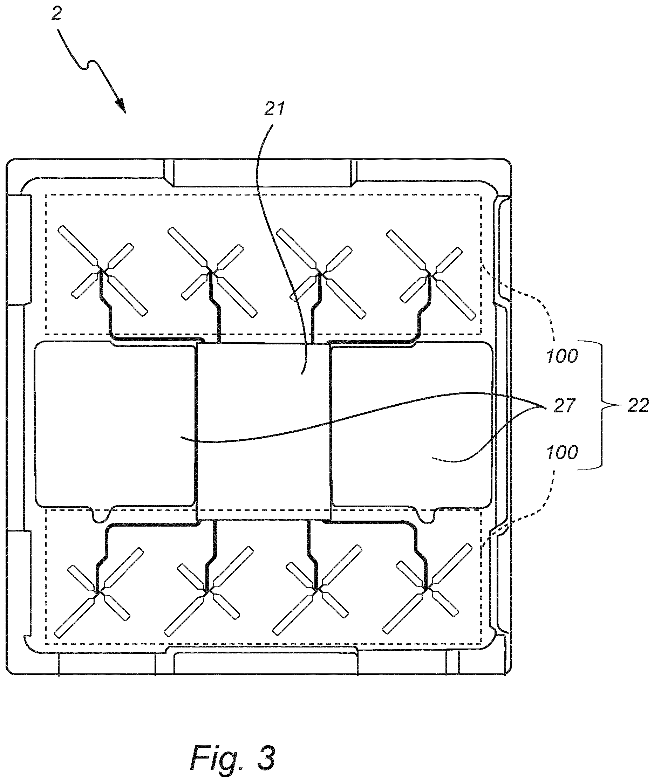

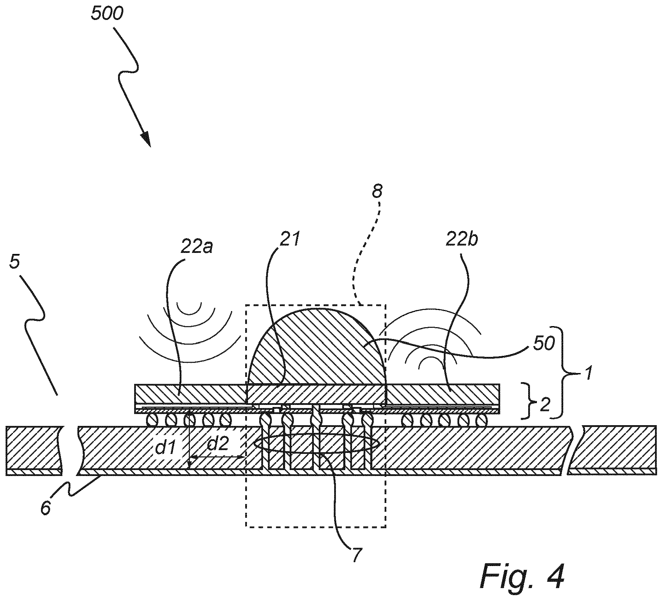

Fig. 1 schematically shows a cross-sectional view of an integrated circuit package 2 according to an exemplifying embodiment of the present invention. The integrated circuit package 2 comprises a first side 2a and second side 2b. The first side 2a and the second side 2b are opposite to each other. The first side 2a comprises bumps 26a, 26b. The bumps 26a, 26b comprise interconnect elements 26a. Further, the bumps 26a, 26b comprise dummy bumps 26b. The integrated circuit package 2 comprises three passivation layers. One of the passivation layers comprises the first side 2a. The passivation layers extend along the length and width of the integrated circuit package 2. The integrated circuit package 2 comprises a first redistribution metal layer, RDL, 25. The first RDL 25 is arranged between two of the passivation layers. The integrated circuit package 2 comprises two antenna arrays 100, see Fig. 3. It is to be understood that each antenna array 100 may comprise a plurality of antennas and/or antenna arrays. The antenna arrays 100 may each comprise at least one crossed dipole antenna 10, see Fig. 2. The antenna arrays 100 are formed in the first RDL 25. The integrated circuit package 2 comprises a die constituting a radio frequency integrated chip, RFIC, 21. The RFIC 21 is arranged on top of the passivation layers, opposite the first side 2a. Further, the RFIC 21 is arranged at the middle of integrated circuit package 2 with regards to the length and width of the integrated circuit package 2. The first RDL 25 is coupled to the RFIC 21. Hence, a portion of the first RDL 25 is extending through one of the passivation layers to the RFIC 21. The antenna arrays 100 are coupled to the RFIC 21 via the first RDL 25. The integrated circuit package 2 comprises a second RDL. A portion of the second RDL is extending through two of the passivation layers to the RFIC 21. The interconnect elements 26a are coupled to the RFIC 21 via the second RDL. The first RDL 25 and the second RDL are arranged between the passivation layers. Hence, the second RDL is arranged between the passivation layer comprising the first side 2a and a middle passivation layer, and the first RDL 25 is arranged between the middle passivation layer and a passivation layer adjacent to the RFIC 21. The integrated circuit package 2 comprises a fan-out area 22. The fan-out area 22 comprises a mold compound. The fan-out area 22 comprises a first fan-out area 22a, and a second fan-out area 22b, see Fig. 4. The first and second fan-out areas 22a, 22b are arranged at the sides of the die 21. The first and second fan-out areas 22a, 22b are the parts of the fan-out area 22 which comprises the at least one antenna array 100. The mold compound of the fan-out area 22 is arranged on top of the passivation layers and the metal redistribution layers, opposite to the first side 2a and around the RFIC 21. A top of the RFIC 21 is exposed. The mold compound does not cover the top of the RFIC 21. However, it is to be understood that the mold compound may be arranged on top of the RFIC 21 as well. A top of the RFIC 21 and the mold compound comprise the second side 2b. The at least one antenna arrays 100 are configured to transmit and/or receive radio signals through the mold compound of the first and second fan-out areas 22a, 22b.

Fig. 2 schematically shows a perspective view of a crossed dipole antenna 10 according to an exemplifying embodiment of the present invention. The perspective view of Fig. 2 shows the crossed dipole antenna 10 as arranged in a plane, wherein the viewing angle is perpendicular to said plane. The crossed dipole antenna 10 is arranged in a first RDL 25, which may be understood as comprising said plane. The crossed dipole antenna 10 may be understood as being formed in, formed by, and or comprised by the first RDL 25. The crossed dipole antenna 10 comprises a first dipole and a second dipole. The first dipole comprises two first legs 11. The second dipole comprises two second legs 12. Further, the crossed dipole antenna 10 comprises two leg pairs 10a, 10b, which may be understood as a first leg pair 10a and a second leg pair 10b. Each leg pair 10a, 10b comprises one first leg 11 of the first dipole and one second leg 12 of the second dipole. The first leg 11 and the second leg 12 of each leg pair 10a, 10b are arranged at a right angle with regards to longitudinal axes of said first leg 11 and said second leg 12. The two first legs 11 are arranged in parallel with regards to the longitudinal axes of the first legs 11. The two first legs 11 are aligned with regards to the longitudinal axes of the first legs 11. The two second legs 12 are arranged in parallel with regards to the longitudinal axes of the second legs 12. The first leg pair 10a and the second leg pair 10b have substantially the same shape. However, the first leg pair 10a and the second leg pair 10b are rotated 180° in the plane with regards to each other. The crossed dipole antenna 10 comprises a center 15. Each leg 11, 12 comprises a proximal end and a distal end. The proximal ends of the legs 11, 12 are arranged at the center 15. The first legs 11 are extending in opposite directions from their respective proximal end towards their respective distal end. The second legs 12 are extending in opposite directions from their respective proximal end towards their respective distal end. A direction of extension of a first leg 11 is perpendicular to a direction of a second leg 12. Hence, the first legs 11 and the second legs 12 may be understood as being arranged in a X-shape, a +-shape or a cross. The first and second legs 11, 12 have rectangular shapes, wherein the shape narrows at the respective proximal ends. Hence, the first and second legs 12 may be understood to have a rectangular arrow shape. The first legs 11 are longer than the second legs 12. Hence, the first legs 11 and the second legs 12 have different lengths. Thereby, the first dipole and the second dipole of the crossed dipole antennas 10 have different dipole lengths. The first legs 11 and the second legs 12 have the same width. A relation between the length and the width of the first legs 11 is 7.2. A relation between the length and the width of the second legs is 4.5. A relation between the length of the first legs 11 and the length of the second legs is 1.62. The different dipole lengths achieve circular polarization of the crossed dipole antenna 10. In other words, the relation between the lengths of the first legs 11 and the second legs 12 is set such that the crossed dipole antenna 10 is circular polarized.

A pair of feed lines 20a, 20b is coupled to the crossed dipole antenna 10. The pair of feed lines 20a, 20b may be understood as comprising a first feed line 20a, and a second feed line 20b. The first feed line 10a is coupled to the first leg pair 10a at the center 15. Each feed line 20a, 20b is split into two portions at the center 15 and the two portions are coupled to a first leg 11 and a second leg 12 of the first leg pair 10a and the second leg pair 10b, respectively. Thereby, the first feed line 20a is coupled to the first leg 11 and the second leg 12 of the first leg pair 10a, and the second feed line 20b is coupled to the second leg pair 10b at the center 15. Thereby, the second feed line 20b is coupled to the first leg 11 and the second leg 12 of the second leg pair 10b. The feed lines 20a, 20b are extending out from the center 15 between the first leg pair 10a and the second leg pair 10b. The feed lines 20a, 20b are extending in a direction of extension, wherein the direction of extension is at angles α, β with regards to the neighboring legs. The angles α, β are 45 degrees. Interference to the crossed dipole antenna 10 caused by the feed lines 20a, 20b is minimal when the angles α, β are 45 degrees. By the term "neighboring legs" it is meant, for example, the two closest legs of the crossed dipole antenna 10, and/or the second leg 12 of the first leg pair 10a and the first leg 11 of the second leg pair 10b. The direction of extension of the feed lines 20a, 20b may optimally reduce interference and/or disturbance of the first and second dipole of the crossed dipole antenna. The feed lines 20a, 20b are arranged adjacent to each other along their extension from the center 15. The feed lines 20a, 20b are extending towards the RFIC 25 (not shown, see Fig. 1 and Fig. 3). The above-mentioned exemplifying embodiment removes the need for crossing of the feed lines that feed the crossed dipole antennas 10, thereby creating a simpler and more compact solution. The abovementioned exemplifying embodiment realizes the crossed dipole antenna 10 in planar technology. In other words, the crossed dipole antenna 10 and the pair of feed lines 20a, 20b are realized in a single RDL of the integrated circuit package 2.

Fig. 3 schematically shows a perspective view of an integrated circuit package 2 according to an exemplifying embodiment of the present invention. The perspective view of Fig. 3 shows the integrated circuit package 2 from below. In other words, the perspective view of Fig. 3 shows the first side 2a of the integrated circuit package 2, wherein the viewing angle is perpendicular to the first side 2a. The integrated circuit package 2, as shown in Fig. 3, has a rectangular shape, comprising four sides. The integrated circuit package 2 comprises an RFIC 25, and a fan-out area 22. The RFIC 25 has a rectangular shape and is arranged at the center of the integrated circuit package 2. Sides of the RFIC 25 are parallel to adjacent sides of the integrated circuit package 2. The fan-out area 22 is arranged around the RFIC 25. The fan-out area 22 comprises two antenna arrays 100. Each antenna array 100 is arranged in a respective fan-out area of the fan-out area 22. One of the antenna arrays 100 is arranged in the first fan-out area 22a of the fan-out area 22, and the other one of the antenna arrays 100 is arranged in the second fan-out area 22b of the fan-out area 22. The fan-out area 22 further comprises two grounding portions 27. The grounding portions 27 are configured to reduce interference and/or disturbance between the RFIC 25 and the antenna arrays 100, and between antenna arrays 100. The grounding portions 27 may comprise grounding vias and/or grounding lines. Each grounding portion 27 is arranged between a side of the RFIC 25, a side of the integrated circuit package 2 adjacent to said side of the RFIC 25, and the two antenna arrays 100.

Each antenna array 100 comprises four crossed dipole antennas 10. The four dipole antennas 10 of each antenna array 100 are arranged in a row. The two rows are parallel with a width of the integrated circuit package 2. The four dipole antennas 10 are arranged such that the longitudinal axis of the first dipole 11 of each dipole antenna 10 is parallel to a diagonal of the first side 2a of the integrated circuit package 2. The four dipole antennas 10 of each antenna array 100 are similarly oriented. The integrated circuit package 2 comprises eight pairs of feed lines 20a, 20b. Each pair of feed lines 20a, 20b is coupled to a respective crossed dipole antenna 10. The feed lines 20a, 20b coupled to the two crossed dipole antennas 10 arranged in the middle of the row of four dipole antennas 10 of each antenna array 100 are extending from the center 15 of its respective crossed dipole antenna 10 to the RFIC 25. A first portion of the feed lines 20a, 20b of the two crossed dipole antennas 10 arranged at the beginning and the end of the row of four dipole antennas 10 of each antenna array 10 are extending from the center 15 of its respective crossed dipole antenna 10 towards the closest grounding portion 27. A second portion of the feed lines 20a, 20b of the two crossed dipole antennas 10 arranged at the beginning and the end of the row of four dipole antennas 10 of each antenna array 10 are extending from the first portion of said feed lines 20a, 20b to the RFIC 25.

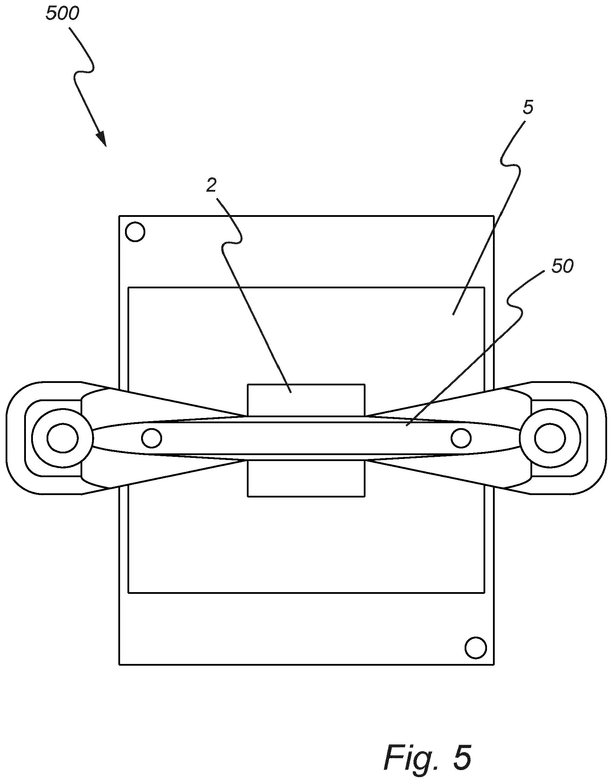

The integrated circuit package 2 comprises a plurality of bumps 26a, 26b. The bumps arranged at the RFIC 25 are interconnect elements 26a. The interconnect elements 26a may be understood as, for example, soldering bumps. The interconnect elements 26a are configured for coupling the integrated circuit package 2 to a PCB 5 (not shown; see Fig. 4 and Fig. 5) and/or another circuit. The bumps arranged at the fan-out area are dummy bumps 26b. The dummy bumps 26b are arranged around each crossed dipole antenna 10. The dummy bumps 26b may not be configured to be coupled to another circuit. The dummy bumps 26b may be configured to provide support and or stability for the integrated circuit package 2 when coupled to a PCB 5 or circuit. Further, the dummy bumps 26b may be configured to reduce disturbance and/or interference between the RFIC 25 and the crossed dipole antennas 10 or between dipole antennas 10.

Fig. 4 schematically shows a cross-sectional view of a system 500 according to an exemplifying embodiment of the present invention. The system 500 comprises an arrangement 1 and a printed circuit board 5. The arrangement 1 comprises an integrated circuit package 2 and a heatsink element 50. The heatsink element 50 is arranged on the RFIC 25 of the integrated circuit package 2. The heatsink element 50 is arranged between the first fan-out area 22a and the second fan-out area 22b of the integrated circuit package 2. The heatsink element 50 has a curved shape, which may be understood as a semicircular shape comprising a bottom. The bottom of the heatsink element 50 is arranged on the RFIC 25. The heatsink element 50 is widest at the bottom. The shape and placement of the heatsink element 50 may be adapted to reduce interference and/or disturbance between the antenna arrays 100, and may increase the performance of beam steering of the antenna arrays 100. The arrangement 1 is mounted to the PCB 5. The arrangement 1 is mounted to the PCB by solder bumps 26a, 26b. The solder bumps 26b are arranged below the fan-out areas 22a, 22b. The solder bumps 26a comprise interconnect elements and are configured to connect the integrated circuit package 2 to the PCB 5. The solders bumps 26a, 26b are a part of the design, and provide an increased antenna performance and mechanical stability for the integrated circuit package 2. The PCB 5 comprises a reflective metal layer 6. The reflective metal layer 6 is arranged at a bottom side of the PCB 5, which is opposite to a side of the PCB on which the integrated circuit package 2 is mounted. The integrated circuit package 2 is arranged to the PCB 5 such that the antenna arrays 100 of the integrated circuit package 2 are arranged at a first distance d1 from the reflective metal layer 6. The first distance d1 is measured in a direction which is perpendicular to the reflective metal layer 6. By arranging the antenna arrays 100 at the first distance d1 from the reflective metal layer 6 results in constructive interference and/or an increased gain for the antenna arrays 100.

The PCB 5 comprises a plurality of vias 7. The plurality of vias 7 are configured for reflection of antenna signals of the antenna arrays 100. The plurality of vias 7 are arranged along a shape associated with a shape of a perimeter of the RFIC 25. The integrated circuit package 2 is arranged to the PCB 5 such that the plurality of vias 7 are arranged along and/or around the perimeter, or arranged along and/or around at a distance to the perimeter, of the RFIC 25. The plurality of vias 7 may comprise vias within the perimeter of the RFIC 25 as well. The integrated circuit package 2 is arranged to the PCB 5 such that the antenna arrays 100 of the integrated circuit package 2 are arranged at a second distance d2 from the plurality of vias 7. The second distance d2 is measured in a direction which is parallel with the reflective metal layer 6. In other words, the second distance d2 is measured in a direction which is perpendicular to the first distance d1. The second distance d2 is measured from a center of an antenna array 100 to the plurality of vias 7. It may be understood that the second distance d2 is the shortest distance between the center of the antenna array 100 and the plurality of vias 7.The heatsink element 50, the RFIC 25 and the plurality of vias 7 together form a side wall reflector 8. The side wall reflector 8 may be understood as an electric wall. The side wall reflector 8 may increase the gain of the antenna arrays 100. The antenna arrays 100 are configured for transmission and/or reception at a specific wavelength (i.e. at a specific frequency). The first distance d1 is equal to a quarter of the specific wavelength. The second distance d2 is equal to a one-half of the specific wavelength. The combination of the side wall reflector 8 and the reflective metal layer 6 may be understood as corner reflector antenna. The corner reflector antenna may further increase the constructive interference and/or the gain for the antenna arrays 100.

Fig. 5 schematically shows a perspective view of a system 500 according to an exemplifying embodiment of the present invention. The system 500 comprises an integrated circuit package 2, a heatsink element 50 and a PCB 5. A first side 2a of the integrated circuit package 2 is soldered to the PCB 5 at a center of the PCB 5. The heatsink element 50 is arranged on the second side 2b of the integrated circuit package 2. The heatsink element 50 has a longitudinal extension. The heatsink element 50 comprises two end sections and a middle section. The middle section of the heatsink element 50 is arranged along a middle portion of the integrated circuit package 2. The middle portion of the integrated circuit package 2 comprises the RFIC 25 and grounding portions 27. The first fan-out area 22a and the second fan-out area 22b of the integrated circuit package 2 is not covered by the heatsink element 50. The width of the middle section of the heatsink element 50 approximately equal to a width or heigh of the RFIC 25. Thereby, the disturbance by the heatsink element 50 to the antenna arrays 100 comprised in the first and second fan-out areas 22a, 22b is reduced. Further, the end sections of the heatsink element 50 widen from the middle section toward respective longitudinal ends of the heatsink element 50. Each end section of the heatsink element 50 comprises two fastening holes. One of the fastening holes of each end section is configured for receiving a fastening means, such as a screw or a nut, for attaching the heatsink element 50 to the PCB 5. The other of the fastening holes of each end section is configured for receiving a fastening means, such as a screw or a nut, for attaching the system 500 to a housing and/or an auxiliary device. The shape of the heatsink element 50 is configured for reflecting the signal transmitted and/or received by the antenna arrays 100. In other words, the shape of the heatsink element 50 is configured for increasing the gain of the antenna arrays 100.

The person skilled in the art realizes that the present invention by no means is limited to the preferred embodiments described above. On the contrary, many modifications and variations are possible within the scope of the appended claims.

## Claims

1. An integrated circuit package (2) comprising
a transceiver radio-frequency integrated circuit, RFIC, (21);
at least one antenna array (100) formed in a redistribution metal layer, RDL, (25) of the integrated circuit package, and arranged in a fan-out area (22a, 22b) of the integrated circuit package, and comprising at least one crossed dipole antenna (10),
each crossed dipole antenna comprising
a first dipole comprising two first legs (11),
a second dipole comprising two second legs (12), and two leg pairs (10a, 10b), each leg pair comprising one first leg of the first dipole and one second leg of the second dipole;
the integrated circuit package further comprising at least one pair of feed lines (20a, 20b) formed in the RDL, wherein each feed line of each pair of feed lines (20a, 20b) is coupled between a respective leg pair of a respective crossed dipole antenna and the RFIC, and wherein each pair of feed lines is extending from a center (15) of the respective crossed dipole antenna towards the RFIC between a neighboring first leg and a neighboring second leg of the two leg pairs of the respective crossed dipole antenna, wherein the neighboring first leg and the neighboring second leg belong to different leg pairs of the two leg pairs.

2. An integrated circuit package (2) according to claim 1, wherein the at least one antenna array and the at least one pair of feed lines are arranged in a plane of the redistribution metal layer.

3. An integrated circuit package (2) according to claim 1 or 2, wherein each pair of feed lines are extending from the center (15) of the respective crossed dipole antenna in a first direction, wherein the first direction is arranged at an angle of substantially 45° with regards to longitudinal axes of the neighboring first leg and the neighboring second leg.

4. An integrated circuit package (2) according to any of the preceding claims, wherein each crossed dipole antenna (10) is a circular polarized antenna.

5. An integrated circuit package (2) according to any of the preceding claims, wherein a relation between a first length of each first leg of the at least one crossed dipole antenna and a second length of each second leg of the at least one crossed dipole antenna is between 1.52 and 1.68.

6. An integrated circuit package (2) according to any of the preceding claims, wherein the first legs of each crossed dipole antenna has a first length such that each first dipole of each crossed dipole antenna has a first angle of input admittance and the second legs of each crossed dipole antenna has a second length such that each second dipole of each crossed dipole antenna has a second angle of input admittance, and wherein the first angle of input admittance and the second angle of input admittance differ by 90°.

7. An integrated circuit package (2) according to any of the preceding claims,
wherein
the two feed lines of each pair of feed lines are each fed a signal by the RFIC, wherein the two signals fed to said two feed lines of each pair of feed lines have a phase difference of 180°.

8. An integrated circuit package (2) according to any of the preceding claims, further comprising at least two antenna arrays, and
wherein a first antenna array of the at least two antenna arrays is arranged in a first fan-out area (22a) of the fan-out area (22), and
wherein a second antenna array of the at least two antenna arrays is arranged in a second fan-out area (22b) of the fan-out area (22);
wherein the first fan-out area and the second fan-out area are arranged at opposite sides of the RFIC.

9. An integrated circuit package (1) according to claim 8, wherein each antenna array comprises at least four crossed dipole antennas.

10. An arrangement (1) comprising
an integrated circuit package (2) according to claim 8 or 9; and
a heatsink element (50) arranged on the RFIC of the integrated circuit package and between the first fan-out area and the second fan-out area.

11. A system (500) comprising
an arrangement (1) according to claim 10; and
a printed circuit board, PCB, (5), wherein
the arrangement (1) is mounted to the printed circuit board (5).

12. A system (500) according to claim 11, wherein the PCB comprises:
a reflective metal layer (6), and
a plurality of vias (7);
wherein the RFIC of the printed circuit board is mounted at the plurality of vias.

13. A system (500) according to claim 12, wherein
the at least one antenna array of the arrangement is configured for communication at a specific wavelength, and wherein
the at least one antenna array is arranged at a first distance from the reflective metal layer and at a second distance from the plurality of vias, wherein
the first distance is a quarter of the specific wavelength, and
the second distance is between one-half and three-quarters of the specific wavelength.

14. A system (500) according to any of claims 12 to 13, wherein the heatsink element, the RFIC and the plurality of vias form a reflector wall, wherein the reflector walls is configured to increase the gain of the at least one antenna array.

15. A system (500) according to any of claim 14, wherein the reflective metal layer and the reflector wall form a corner reflector antenna, wherein the corner reflector antenna is configured to increase the gain of the at least one antenna array.

## Patentansprüche

1. Gehäuse (2) für integrierte Schaltungen, umfassend
eine integrierte Sendeempfänger-Hochfrequenzschaltung (RFIC) (21);
mindestens ein Antennen-Array (100), das in einer Metallumverteilungsschicht (RDL) (25) des Gehäuses für integrierte Schaltungen ausgebildet ist und in einem Ausfächerungsbereich (22a, 22b) des Gehäuses für integrierte Schaltungen angeordnet ist und mindestens eine gekreuzte Dipolantenne (10) umfasst,
wobei jede gekreuzte Dipolantenne Folgendes umfasst
einen ersten Dipol, der zwei erste Schenkel (11) umfasst,
einen zweiten Dipol, der zwei zweite Schenkel (12) umfasst, und
zwei Schenkelpaare (10a, 10b), wobei jedes Schenkelpaar einen ersten Schenkel des ersten Dipols und einen zweiten Schenkel des zweiten Dipols umfasst;
wobei das Gehäuse für integrierte Schaltungen ferner mindestens ein Paar von Speiseleitungen (20a, 20b) umfasst, die in der RDL ausgebildet sind, wobei jede Speiseleitung von jedem Paar von Speiseleitungen (20a, 20b) zwischen einem jeweiligen Schenkelpaar einer jeweiligen gekreuzten Dipolantenne und der RFIC gekoppelt ist, und wobei sich jedes Paar von Speiseleitungen von einer Mitte (15) der jeweiligen gekreuzten Dipolantenne hin zu der RFIC zwischen einem benachbarten ersten Schenkel und einem benachbarten zweiten Schenkel der zwei Schenkelpaare der jeweiligen gekreuzten Dipolantenne erstreckt, wobei der benachbarte erste Schenkel und der benachbarte zweite Schenkel unterschiedlichen Schenkelpaaren der zwei Schenkelpaare angehören.

2. Gehäuse (2) für integrierte Schaltungen nach Anspruch 1, wobei das mindestens eine Antennen-Array und das mindestens eine Paar von Speiseleitungen in einer Ebene der Metallumverteilungsschicht angeordnet sind.

3. Gehäuse (2) für integrierte Schaltungen nach Anspruch 1 oder 2, wobei sich jedes Paar von Speiseleitungen von der Mitte (15) der jeweiligen gekreuzten Dipolantenne in einer ersten Richtung erstreckt, wobei die erste Richtung in Bezug auf Längsachsen des benachbarten ersten Schenkels und des benachbarten zweiten Schenkels in einem Winkel von im Wesentlichen 45° angeordnet ist.

4. Gehäuse (2) für integrierte Schaltungen nach einem der vorhergehenden Ansprüche, wobei jede gekreuzte Dipolantenne (10) eine zirkularpolarisierte Antenne ist.

5. Gehäuse (2) für integrierte Schaltungen nach einem der vorhergehenden Ansprüche, wobei ein Verhältnis zwischen einer ersten Länge von jedem ersten Schenkel der mindestens einen gekreuzten Dipolantenne und einer zweiten Länge von jedem zweiten Schenkel der mindestens einen gekreuzten Dipolantenne zwischen 1,52 und 1,68 beträgt.

6. Gehäuse (2) für integrierte Schaltungen nach einem der vorhergehenden Ansprüche, wobei die ersten Schenkel von jeder gekreuzten Dipolantenne eine erste Länge derart aufweist, dass jeder erste Dipol von jeder gekreuzten Dipolantenne einen ersten Eingangsadmittanzwinkel aufweist, und die zweiten Schenkel von jeder gekreuzten Dipolantenne eine zweite Länge derart aufweist, dass jeder zweite Dipol von jeder gekreuzten Dipolantenne einen zweiten Eingangsadmittanzwinkel aufweist, und wobei der erste Eingangsadmittanzwinkel und der zweite Eingangsadmittanzwinkel um 90° voneinander abweichen.

7. Gehäuse (2) für integrierte Schaltungen nach einem der vorhergehenden Ansprüche, wobei den zwei Speiseleitungen von jedem Paar von Speiseleitungen jeweils ein Signal von der RFIC zugeführt wird, wobei die zwei Signale, die den zwei Speiseleitungen von jedem Paar von Speiseleitungen zugeführt werden, eine Phasendifferenz von 180° aufweisen.

8. Gehäuse (2) für integrierte Schaltungen nach einem der vorhergehenden Ansprüche, das ferner mindestens zwei Antennen-Arrays umfasst, und
wobei ein erstes Antennen-Array der mindestens zwei Antennen-Arrays in einem ersten Ausfächerungsbereich (22a) des Ausfächerungsbereichs (22) angeordnet ist, und
wobei das zweite Antennen-Array der mindestens zwei Antennen-Arrays in einem zweiten Ausfächerungsbereich (22b) des Ausfächerungsbereichs (22) angeordnet ist;
wobei der erste Ausfächerungsbereich und der zweite Ausfächerungsbereich auf gegenüberliegenden Seiten der RFIC angeordnet sind.

9. Gehäuse (1) für integrierte Schaltungen nach Anspruch 8, wobei jedes Antennen-Array mindestens vier gekreuzte Dipolantennen umfasst.

10. Anordnung (1), umfassend
ein Gehäuse (2) für integrierte Schaltungen nach Anspruch 8 oder 9; und
ein Kühlkörperelement (50), das auf der RFIC des Gehäuses für integrierte Schaltungen und zwischen dem ersten Ausfächerungsbereich und dem zweiten Ausfächerungsbereich angeordnet ist.

11. System (500), umfassend
eine Anordnung (1) nach Anspruch 10; und
eine Leiterplatte (PCB) (5), wobei
die Anordnung (1) an der Leiterplatte (5) angebracht ist.

12. System (500) nach Anspruch 11, wobei die PCB Folgendes umfasst:
eine reflektierende Metallschicht (6), und
mehrere Durchkontaktierungen (7);
wobei die RFIC der Leiterplatte an den mehreren Durchkontaktierungen angebracht ist.

13. System (500) nach Anspruch 12, wobei
das mindestens eine Antennen-Array der Anordnung zur Kommunikation mit einer spezifischen Wellenlänge konfiguriert ist, und wobei
das mindestens eine Antennen-Array in einem ersten Abstand zu der reflektierenden Metallschicht und in einem zweiten Abstand zu den mehreren Durchkontaktierungen angeordnet ist, wobei
der erste Abstand ein Viertel der spezifischen Wellenlänge beträgt, und
der zweite Abstand zwischen einer Hälfte und drei Vierteln der spezifischen Wellenlänge beträgt.

14. System (500) nach einem der Ansprüche 12 bis 13, wobei das Kühlkörperelement, die RFIC und die mehreren Durchkontaktierungen eine Reflektorwand bilden, wobei die Reflektorwände so konfiguriert ist, dass sie die Verstärkung des mindestens einen Antennen-Arrays erhöht.

15. System (500) nach einem der Ansprüche 14, wobei die reflektierende Metallschicht und die Reflektorwand eine Winkelreflektorantenne bilden, wobei die Winkelreflektorantenne so konfiguriert ist, dass sie die Verstärkung des mindestens einen Antennen-Arrays erhöht.

## Revendications

1. Boîtier de circuit intégré (2) comprenant un circuit intégré à radiofréquence
d'émetteur-récepteur, RFIC, (21) au moins un réseau d'antennes (100) formé dans une couche métallique de
redistribution, RDL, (25) du boîtier de circuit intégré, et agencé dans une zone de sortance (22a, 22b) du boîtier de circuit intégré, et comprenant au moins une antenne dipôle croisée (10),
chaque antenne dipôle croisée comprenant
un premier dipôle comprenant deux premières branches (11),
un deuxième dipôle comprenant deux deuxièmes branches (12), et
deux paires de branches (10a, 10b), chaque paire de branches comprenant une première branche du premier dipôle et une deuxième branche du deuxième dipôle,
le boîtier de circuit intégré comprenant en outre au moins une paire de lignes d'alimentation (20a, 20b) formé dans le RDL, dans lequel chaque ligne d'alimentation de chaque paire de lignes d'alimentation (20a, 20b) est couplé entre une paire de branches respective d'une antenne dipôle croisée respective et le RFIC et dans lequel chaque paire de lignes d'alimentation s'étend depuis un centre (15) de l'antenne dipôle croisée respective vers le RFIC entre une première branche voisine et une deuxième branche voisine des deux paires de branches de l'antenne dipôle croisée respective, la première branche voisine et la deuxième branche voisine appartenant à des paires de branches différentes des deux paires de branches.

2. Boîtier de circuit intégré (2) selon la revendication 1, dans lequel le au moins un réseau d'antennes et la au moins une paire de lignes d'alimentation sont disposés dans un plan de la couche métallique de redistribution.

3. Boîtier de circuit intégré (2) selon la revendication 1 ou 2, dans lequel chaque paire de lignes d'alimentation s'étend depuis le centre (15) de l'antenne dipôle croisée respective dans une première direction, la première direction étant disposée à un angle de sensiblement 45° par rapport aux axes longitudinaux de la première branche voisine et de la deuxième branche voisine.

4. Boîtier de circuit intégré (2) selon une quelconque des revendications précédentes, dans lequel chaque antenne dipôle croisée (10) est une antenne à polarisation circulaire.

5. Boîtier de circuit intégré (2) selon une quelconque des revendications précédentes, dans lequel une relation entre une première longueur de chaque première branche de la au moins une antenne dipôle croisée et une deuxième longueur de chaque deuxième branche de la au moins une antenne dipôle croisée est comprise entre 1,52 et 1,68.

6. Boîtier de circuit intégré (2) selon une quelconque des revendications précédentes, dans lequel les premières branches de chaque antenne dipôle croisée ont une première longueur telle que chaque premier dipôle de chaque antenne dipôle croisée a un premier angle d'admittance d'entrée et les deuxièmes branches de chaque antenne dipôle croisée ont une deuxième longueur telle que chaque deuxième dipôle de chaque antenne dipôle croisée a un deuxième angle d'admittance d'entrée, et dans lequel le premier angle d'admittance d'entrée et le deuxième angle d'admittance d'entrée diffèrent de 90° .

7. Boîtier de circuit intégré (2) selon une quelconque des revendications précédentes, dans lequel les deux lignes d'alimentation de chaque paire de lignes d'alimentation reçoivent chacune un signal par le RFIC, dans lequel les deux signaux alimentés auxdites deux lignes d'alimentation de chaque paire de lignes d'alimentation ont une différence de phase de 180°.

8. Boîtier de circuit intégré (2) selon une quelconque des revendications précédentes, comprenant en outre au moins deux réseaux d'antennes, et
dans lequel un premier réseau d'antennes des au moins deux réseaux d'antennes est agencé dans une première zone de sortance (22a) de la zone de sortance (22), et
dans lequel un deuxième réseau d'antennes des au moins deux réseaux d'antennes est agencé dans une deuxième zone de sortance (22b) de la zone de sortance (22);
dans lequel la première zone de sortance et la deuxième zone de sortance sont disposées sur des côtés opposés du RFIC.

9. Boîtier de circuit intégré (2) selon la revendication 8, dans lequel chaque réseau d'antennes comprend au moins quatre antennes dipôles croisées.

10. Agencement (1) comprenant
un boîtier de circuit intégré (2) selon la revendication 8 ou 9 ; et
un élément de dissipateur thermique (50) agencé sur le RFIC du boîtier de circuit intégré et entre la première zone de sortance et la deuxième zone de sortance.

11. Système (500) comprenant
un agencement (1) selon la revendication 10 ; et
une carte de circuit imprimé, PCB, (5), dans lequel l'agencement (1) est monté sur la carte de circuit imprimé (5).

12. Système (500) selon la revendication 11, dans lequel le PCB comprend :
une couche métallique réfléchissante (6) et
une pluralité de traversées (7) ;
dans lequel le RFIC de la carte de circuit imprimé est monté au niveau de la pluralité de traversées.

13. Système (500) selon la revendication 12, dans lequel
le au moins un réseau d'antennes de l'agencement est configuré pour une communication à une longueur d'onde spécifique, et dans lequel
le au moins un réseau d'antennes est agencé à une première distance de la couche métallique réfléchissante et à une deuxième distance de la pluralité de traversées, dans lequel la première distance est un quart de la longueur d'onde spécifique, et
la deuxième distance est comprise entre la moitié et les trois quarts de la longueur d'onde spécifique.

14. Système (500) selon une quelconque des revendications 12 à 13, dans lequel l'élément de dissipateur thermique, le RFIC et la pluralité de traversées forment une paroi de réflecteur, dans laquelle les parois de réflecteur sont configurées pour augmenter le gain du au moins un réseau d'antennes.

15. Système (500) selon une quelconque des revendications 14, dans lequel la couche métallique réfléchissante et la paroi de réflecteur forment une antenne à réflecteur d'angle, dans lequel l'antenne à réflecteur d'angle est configurée pour augmenter le gain du au moins un réseau d'antennes.
